(19) **Europäisches Patentamt European Patent Office Office européen des brevets**

(11) **EP 4 489 243 B1**

(12) **EUROPEAN PATENT SPECIFICATION**

(45) Date of publication and mention of the grant of the patent:
**04.02.2026 Bulletin 2026/06**

(21) Application number: **24203753.9**

(22) Date of filing: **30.09.2024**

(51) International Patent Classification (IPC):
*H02H 3/16* (2006.01)     *G01R 31/08* (2020.01)
*H02H 3/44* (2006.01)     *G01R 19/12* (2006.01)

(52) Cooperative Patent Classification (CPC):
**H02H 3/16; G01R 31/085; G01R 31/088; H02H 3/445;** G01R 19/12; Y04S 10/52

(54) **METHOD FOR DETECTING AND LOCATING NEGATIVE POLE TO EARTH FAULT ON THE FOURTH-RAIL DC TRACTION SYSTEMS**

VERFAHREN ZUR ERKENNUNG UND ORTUNG EINES NEGATIVEN POLS ZU EINEM ERDSCHLUSS AUF DEN VIERTEN SCHIENEN-GLEICHSTROMANTRIEBSSYSTEMEN

PROCÉDÉ DE DÉTECTION ET DE LOCALISATION DE DÉFAUT DE PÔLE NÉGATIF PAR RAPPORT À LA TERRE SUR LES SYSTÈMES DE TRACTION CC À QUATRIÈME RAIL

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **30.10.2023  CN 202311421438**

(43) Date of publication of application:
**08.01.2025  Bulletin 2025/02**

(73) Proprietor: **Tianjin Keyvia Electric Co., Ltd.**
**Tianjin 300384 (CN)**

(72) Inventors:
• **XIA, Fubing**
  **Tianjin 300384 (CN)**
• **SONG, Jinchuan**
  **Tianjin 300384 (CN)**
• **WANG, Ye**
  **Tianjin 300384 (CN)**
• **WANG, Chuanqi**
  **Tianjin 300384 (CN)**
• **WANG, Zhen**
  **Tianjin 300384 (CN)**
• **LI, Zhe**
  **Tianjin 300384 (CN)**
• **SUN, Yuanyuan**
  **Tianjin 300384 (CN)**
• **YAN, Zhaohui**
  **Tianjin 300384 (CN)**
• **ZHAO, Shuangshi**
  **Tianjin 300384 (CN)**

(74) Representative: **JD&P Patent Attorneys**
**Joanna Dargiewicz & Partners**
**ul. Mysliborska 93A/50**
**03-185 Warszawa (PL)**

(56) References cited:
**CN-A- 111 478 298     CN-A- 116 500 378**
**CN-B- 102 126 445**

EP 4 489 243 B1

**Description**

**TECHNICAL FIELD**

The present disclosure belongs to the technical field of rail transit, and particularly relates to a method for detecting and locating negative pole to earth fault on the fourth-rail DC traction systems.

**BACKGROUND**

With the acceleration of urbanization process and rapid growth of urban populations, the issue of urban traffic congestion has been becoming a major obstacle restricting the economic and social development of large and medium-sized cities. In order to change this passive situation as soon as possible, some big cities, provincial capitals, and coastal central cities are continuously building new urban rail transit lines. As an important component of urban transportation, the safety, reliability, and operational efficiency of metro have always been a focus of attention. Currently, most urban rail transit systems use DC power supply based on track rails as return circuit. However, the major drawback of this power supply method is that stray currents leaking from the rails to the earth can cause galvanic corrosion to the metal infrastructure in tunnels and nearby buildings and metal pipelines. To address this issue, some scholars have proposed one DC power supply technology use an independent rail as return circuit, where the power does not backflow to the traction substation through the running rails but through this independent rail (also called the fourth rail).

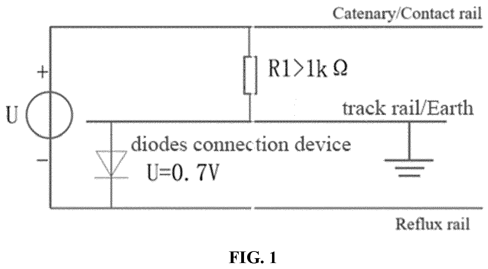

Although the DC power supply systems based on fourth rail as return circuit solves the significant issue of stray currents, it also has its drawbacks. Specifically, when short circuit fault between positive pole to earth (due to the nearly same insulation level between the positive and negative poles to earth), the fault current is very small, conventional DC protection cannot protect the single pole to earth fault. One kind of method to solve this problem is connecting diodes in series between the negative pole and earth, as shown in Figure 1. The principle is that short circuit fault current of the positive pole to earth will directly flow back to the negative pole through diodes, so the conventional feeder protection can operate and cut off the fault.

Examples of conventional feeder protection in a fourth-rail DC traction system are disclosed in patent publications CN 116 500 378, and in CN 111 478 298.

This will have a problem which is how to protect and locate the short circuit fault of negative pole-to-earth, because the diodes connection results in very low voltage between the negative pole and earth (0.7V approximately), making it difficult to detect short circuit current between negative and earth under normal operating conditions. Only when a train passes through the fault section will have part of load-circuit current flow the diodes and can be detected. This invention relates to how to utilize this load current to detect fault and distinguish the fault section of negative pole to earth on the fourth-rail DC traction systems.

Once the fault section confirmed, fault distance measurement becomes important and possible, as it can quickly and accurately locate the fault point. This function has a great significance for improving maintenance effectively and ensuring the safety and stable operation of the metro, as well as improving the quality of metro services.

**SUMMARY OF PRESENT INVENTION**

In view of this, this invention aims to propose a method for detecting and locating negative pole to earth fault on the fourth-rail DC traction systems, so as to solve the technical problem that existing DC protection in traction substations being unable to ascertain the short circuit location point of negative-to-earth fault.

To achieve the above purpose, this invention adopts the following technical solutions.

A method for detecting and locating negative pole to earth fault on the fourth-rail DC traction systems, comprising:

Sampling a current from a feeder and a diode-connection device when preset current variation analysis conditions are met;

Acquiring a time tag when the current through the diode-connection device reach a target threshold and then executing a preset fault determination strategy;

Obtaining values of parameters required at the time tag and input the values into a parameter matrix;

Solving the parameter matrix to obtain calculation results and inferring a fault point based on the calculation results.

Further, the preset current variation analysis conditions include:

Detecting a current $I_d$ flow the diode-connection device in real-time, determining whether the current $I_d$ exceeds a set value $I_{set}$, and when the current $I_d$ exceeds the set value $I_{set}$, starting current variation analysis.

Further, the preset fault determination strategy includes:

Getting a current sample value of the diode-connection devices from neighboring substations on both sides of a local substation through a GOOSE (Generic Object-Oriented Substation Event) network, and determining that the neighboring substation with the higher current sample value is the side experiencing the short-circuit fault.

Further, obtaining the values of the required parameters at the time tag and inputting the values into a parameter matrix includes:

Getting currents $I_1$ and $I_3$ of the feeder and the diode-connection devices of the local substation at the time tag and the currents $I_2$ and $I_4$ of the feeder and diode-connection devices of the neighboring substation at the time tag through the GOOSE network, and inputting these values into the parameter matrix. Further, the current variation analysis includes:

First, initialize a Current Parameter A and a Current Parameter B to 0, record a current value at a current moment, and compare it with the previous moment:

If the current value at the current moment is lower than the previous moment, then the current value of previous moment is considered as a local maximum, update the current parameter A to the local maximum value;

If the Parameter A is higher than the Parameter B, update the Parameter B to the value of the Parameter A, and record the current values of the local feeder, neighboring feeder, and the current values of diode-connection device through the GOOSE network;

If the current value at the current moment is higher than the previous moment, it is considered that the current is rising, and the Current Parameter A is not updated.

Furthermore, the preset fault determination strategy includes:

Obtain a current $I_{dl}$ of the diode-connection device on a left side of the substation and a current $I_{dr}$ of the diode-connection device on a right side of the substation at this moment through the GOOSE network. If $I_{dl} > I_{dr}$ then it is determined that the fault occurred in the left section of the substation; otherwise, it is determined that the fault occurred in the right section of the substation.

Furthermore, obtaining values of the required parameters at the corresponding time, and inputting the values into a parameter matrix, includes:

Taking a current $I_3$ of the diode-connection device at the corresponding time in the local station, using the GOOSE network to get a current $I_4$ of the diode-connection device at the neighboring station at this moment, along with the feeder currents $I_2$ and $I_1$ of the neighboring and local stations, respectively, and entering them into the following system of equations:

$$\begin{cases} \left[(\alpha+\beta)(R_1+R_3)+R_4\right]I_1 + R_4 I_2 - \alpha R_1 I_4 + \alpha R_3 I_3 = 0 \\ \left[(\alpha+\beta)(R_2-R_3)+R_4\right]I_2 + R_4 I_1 - \alpha(R_2-R_3)I_3 = 0 \\ \left[(1+\alpha)R_2+R_5\right]I_3 + \alpha R_3 I_1 - \alpha(R_2-R_3)I_2 + R_5 I_4 = u_1 \\ \left[(1+\alpha)R_1+R_5\right]I_4 - \alpha R_1 I_1 + R_5 I_3 = u_2 \\ R_1 + R_2 = r \end{cases},$$

Arranging into the following matrix:

$$\left(\begin{array}{ccccc|c} (\alpha+\beta)I_1 - \alpha I_4 & 0 & (\alpha+\beta)I_1 + \alpha I_3 & (I_1+I_2) & 0 & 0 \\ 0 & (\alpha+\beta)I_2 - \alpha I_3 & -(\alpha+\beta)I_2 + \alpha I_3 & (I_1+I_2) & 0 & 0 \\ 0 & (\alpha+1)I_3 - \alpha I_2 & \alpha(I_1+I_2) & 0 & (I_3+I_4) & u_1 \\ (\alpha+1)I_4 - \alpha I_1 & 0 & 0 & 0 & (I_3+I_4) & u_2 \\ 1 & 1 & 0 & 0 & 0 & r \end{array}\right),$$

In this formula, $\alpha$ represents a ratio of the contact net unit resistance to the return rail unit resistance, $\beta$ represents a ratio of the contact net unit resistance to the rail unit resistance, $u_1$ is an output voltage of the rectifier on the left side, $u_2$ is an output voltage of the rectifier on the right side, and r is a total resistance of the contact net in this section;

$R_1$ is a contact net resistance on the left side of the train, $R_2$ is a contact net resistance on the right side of the train, $R_3$ is a resistance between the return rail short circuit point and the train's current pickup point, $R_4$ is a equivalent resistance at the short circuit point, and $R_5$ is a train's equivalent resistance.

Furthermore, this scheme discloses an electronic device, including a processor and a memory that communicates with the processor and is used to store processor-executable instructions, where the processor is used to perform a method for judging and measuring the distance of a negative pole to earth fault in the negative pole of a metro fourth-rail traction system.

Furthermore, this scheme discloses a server that includes at least one processor and a memory that communicates with the processor. The memory stores instructions that can be executed by the at least one processor, which, when executed, enable the processor to perform a method for judging and measuring the distance of a negative pole to earth fault in the negative pole of a metro fourth-rail traction system.

Furthermore, this scheme discloses a computer-readable storage medium that stores a computer program, which, when executed by a processor, implements a method for judging and measuring the distance of a negative pole to earth fault in the negative pole of a metro fourth-rail traction system.

Compared to existing technology, the metro fourth-rail traction negative pole to earth fault judging and measuring method described by this invention has the following beneficial effects:

(1) The method described in this invention connects the diode-connection devices to the GOOSE communication network, allowing all diode-connection devices on this line to operate in a networked and coordinated manner. When a negative pole to ground short circuit occurs, it is possible to use the GOOSE network to call analog data from adjacent stations for analysis, accurately locate the fault area, and significantly reduce repair time, playing a crucial role in ensuring the normal operation of high-speed rail;

(2) The method described in this invention implements a fault measuring function for a ground short circuit in a fourth-rail power supply's negative pole.

## BRIEF DESCRIPTION OF THE DRAWINGS

The accompanying drawings which constitute a part of the description of the present disclosure are intended to provide further understanding of the present invention. The exemplary embodiments of the present disclosure and descriptions thereof are intended to be illustrative of the present disclosure and do not constitute an undue limitation of the present disclosure. In the accompanying drawings:

FIG. 1 is a schematic diagram of a unidirectional conduction device according to an embodiment of the present disclosure;

FIG. 2 is a schematic diagram of a substation circuit according to an embodiment of the present disclosure;

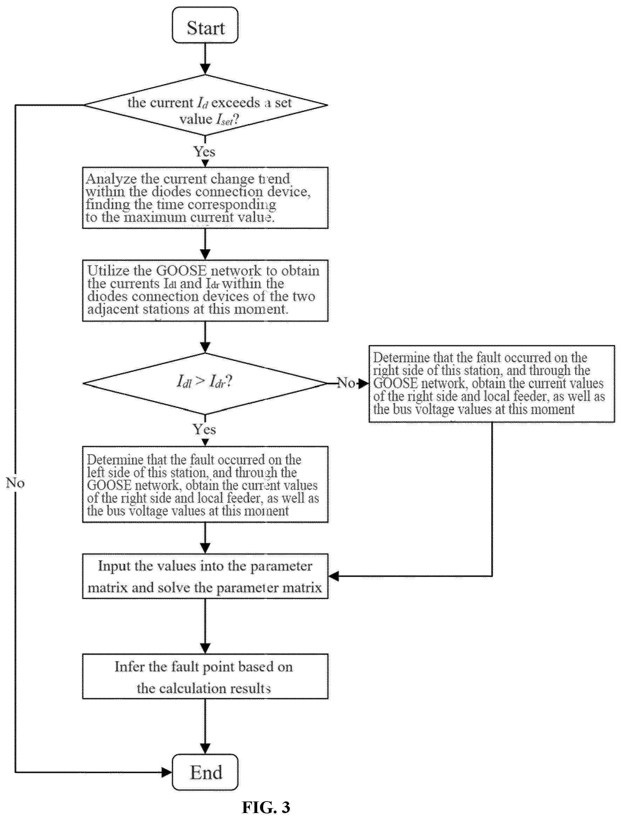

FIG. 3 is a flow chart of a method according to an embodiment of the present disclosure.

## DETAILED DESCRIPTION OF THE EMBODIMENTS

It should be noted that, where not in conflict, the embodiments and features described in this invention can be combined with each other.

The invention will now be described in detail with reference to the accompanying drawings and in conjunction with the embodiments.

An embodiment of the present invention provides a method for measuring the distance of a negative pole to earth fault in the negative pole of a metro-specific rail return power supply system based on GOOSE communication. It connects the ground leakage protection devices inside metro traction stations to the GOOSE fiber optic communication network, allowing all ground leakage protection devices on this line to operate in a networked and coordinated manner. When a negative pole to ground short circuit occurs, it is possible to use the GOOSE network to call analog data from adjacent stations for analysis, accurately locating the fault area. This is crucial for reducing repair times and ensuring the normal operation of high-speed rail, especially for smart traction substations using IEC61850 technology, as it can reuse the existing DC protection GOOSE fiber optic communication network without additional investment in network construction.

The specific steps of the scheme include:

The unidirectional conducting grounding protection device primarily consists of diodes, as shown in Figure 1. The unidirectional conducting grounding protection device identifies negative pole to earth faults in the negative pole by detecting the current within the diodes. Each traction substation's unidirectional conducting grounding protection device must support the GOOSE communication protocol and be connected to the local GOOSE switch, with neighboring station's GOOSE switches cascaded together, and the line lengths between this station and the adjacent ones entered into the protection devices' settings at each substation.

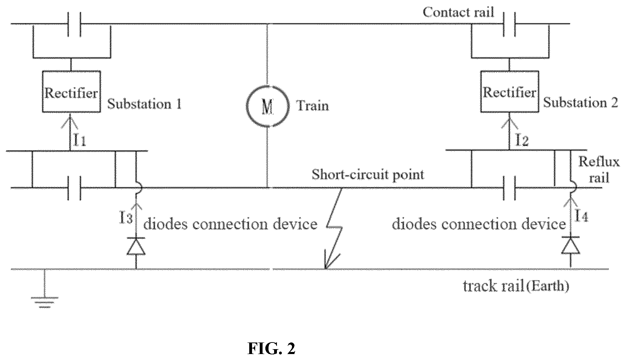

When a negative pole to ground short circuit occurs, as shown in Figure 2, if no locomotive is operating in the section, only a very small diode conduction voltage exists between the negative pole and ground due to the presence of the diode-connection device, and no short circuit current will be present. Only when a locomotive is within the section will a large current be produced in the return rail, and a detectable shunt current will appear within the diode-connection device.

The diode-connection device sets this current; when it detects a current exceeding the set value Iset, it begins to analyze the trend of the short circuit current, initially setting the Current parameter A and Current parameter B to 0, recording the current value at the current moment and comparing it with the previous moment. If the current value at the current moment is lower than the previous moment, then the previous moment is determined to be the local maximum, update the current parameter A to the local maximum value; If the current parameter A is higher than the current parameter B, update the parameter B to the value of the parameter A, and record the current values detected in the local feeder, neighboring feeder, and diode-connection device through the GOOSE network.

If the current value at the current moment is higher than the previous moment, it is considered that the current is rising, and the parameter A will be not updated. Until the current detected by the local diode-connection device falls below the set value Iset, the parameter B is no longer updated and is considered to be the maximum current value collected by the diode-connection device during the train's passage through this section.

Through the GOOSE network, obtain the maximum current value at the moment from the diode-connection device on the left side of the station $I_{dl}$, as well as the current from the diode-connection device on the right side of the station $I_{dr}$. If $I_{dl} > I_{dr}$, then it is determined that the fault occurred in the left interval of the station; otherwise, it is determined that the fault occurred in the right interval of the station.

After determining the fault section, use the current $I_3$ from the diode-connection device at this station and the currents $I_4$ from the neighboring station's diode-connection device, $I_2$ from the neighboring feeder, and $I_1$ from the local feeder read through the GOOSE network to form the following system of equations:

$$\begin{cases} \left[(\alpha+\beta)(R_1+R_3)+R_4\right]I_1 + R_4I_2 - \alpha R_1I_4 + \alpha R_3I_3 = 0 \\ \left[(\alpha+\beta)(R_2-R_3)+R_4\right]I_2 + R_4I_1 - \alpha(R_2-R_3)I_3 = 0 \\ \left[(1+\alpha)R_2+R_5\right]I_3 + \alpha R_3I_1 - \alpha(R_2-R_3)I_2 + R_5I_4 = u_1 \\ \left[(1+\alpha)R_1+R_5\right]I_4 - \alpha R_1I_1 + R_5I_3 = u_2 \\ R_1+R_2 = r \end{cases},$$

Arranging into the following matrix:

$$\begin{pmatrix} (\alpha+\beta)I_1-\alpha I_4 & 0 & (\alpha+\beta)I_1+\alpha I_3 & (I_1+I_2) & 0 & \bigg| & 0 \\ 0 & (\alpha+\beta)I_2-\alpha I_3 & -(\alpha+\beta)I_2+\alpha I_3 & (I_1+I_2) & 0 & \bigg| & 0 \\ 0 & (\alpha+1)I_3-\alpha I_2 & \alpha(I_1+I_2) & 0 & (I_3+I_4) & \bigg| & u_1 \\ (\alpha+1)I_4-\alpha I_1 & 0 & 0 & 0 & (I_3+I_4) & \bigg| & u_2 \\ 1 & 1 & 0 & 0 & 0 & \bigg| & r \end{pmatrix},$$

In the equations, $\alpha$ is the ratio of the unit resistance of the contact network to that of the return rail, and $\beta$ is the ratio of the unit resistance of the contact network to that of the rail. $u_1$ is the output voltage of the rectifier on the left side, $u_2$ is the output voltage of the rectifier on the right side, and r is the total resistance of the contact rail in this section.

$R_1$ is the resistance of the contact network on the left side of the train, $R_2$ is the resistance of the contact network on the right side of the train, $R_3$ is the resistance between the return rail short circuit point and the train's current pickup point, $R_4$ is the equivalent resistance at the short circuit point, and $R_5$ is the equivalent resistance of the train.

This is a full-rank matrix, which can be directly solved for $R_1$, $R_2$, $R_3$, etc., thus placing the fault point at a distance $(R_1+R_3)/k$ from the left side, where $k$ is the unit length resistance of the contact network.

In intelligent substations, diode-connection devices using the aforementioned processing method can achieve the fault measuring function for ground shorts under the independent rail return power supply method.

Technical personnel in this field can realize that the units and method steps described in the examples of the embodiments disclosed herein can be implemented in electronic hardware, computer software, or a combination of both. To clearly illustrate the interchangeability of hardware and software, the components and steps of the examples have been generally described functionally in the foregoing description. Whether these functions are performed by hardware or software depends on specific application and design constraints of the technical solution. Technical professionals can use different methods to implement the described functions for each specific application, but such implementations should not be considered beyond the scope of this invention.

In the several embodiments provided in this application, it should be understood that the disclosed methods and systems can be implemented in other ways. For example, the division of the above-mentioned units is just a logical function division; in actual implementation, there might be other division manners. Multiple units or components can be combined or integrated into another system, or some features can be omitted or not performed. The units shown may or may not be physically separated; components shown as units may or may not be physical units, i.e., they may be located in one place or distributed across multiple network units. Some or all of the units can be chosen to achieve the purposes of the embodiment schemes of this invention according to actual needs.

It should be noted that the above embodiments are only used to illustrate the technical solutions of this invention and not to limit it; despite the detailed explanation of the invention with reference to the foregoing embodiments, those of ordinary skill in the art should understand that they can still modify the described technical solutions or equivalently replace some or all of the technical features, as long as they are included in the scope of the claims and the specification of this invention.

The above is merely a better embodiment of this invention and is not intended to limit this invention. Any modifications, equivalent replacements, improvements, etc., made within the scope of the appended claims is included within the scope of protection of this invention.

**Claims**

1. A method for detecting and locating negative pole to earth fault on the fourth-rail DC traction systems, comprising:

sampling current from a feeder and a diode-connection device when preset current variation analysis conditions are met;
acquiring a time tag when the current through the diode-connection device reaches a target threshold and then executing a preset fault determination strategy;
obtaining values of parameters required at the time tag and inputting the values into a parameter matrix;
solving the parameter matrix to obtain calculation results and inferring a fault point based on the calculation results;
the method **characterized in that** the preset current variation analysis conditions include:

detecting a current $I_d$ flowing through diodes of the diode-connection device in real-time, determining whether the current $I_d$ exceeds a set value $I_{set}$, and when the current $I_d$ exceeds the set value $I_{set}$, starting current variation analysis;
wherein the current variation analysis includes:
initializing a current parameter A and a current parameter B to 0, recording a current value at a current moment, and comparing the current value with a current at a previous moment:

when the current value at the current moment is lower than the current value at the previous moment, the current value at the previous moment is considered as a local maximum, update the current parameter A to the local maximum value;
when the current parameter A is higher than the current parameter B, updating the current parameter B to the current parameter A, and recording current values of the feeder of a local substation and the feeder of a neighboring substation as well as current values of the diode-connection device through a generic object-oriented substation event (GOOSE) network;
when the current value at the current moment is higher than the current value at the previous moment, the current is considered to be rising, and the current parameter A is not updated;
wherein the preset fault determination strategy includes:

obtaining a current $I_{dl}$ of the diode-connection device on a left side of the local substation at the current moment and a current $I_{dr}$ of the diode-connection device on a right side of the local substation at the current moment through the GOOSE network, and determining that when $I_{dl} > I_{dr}$, the fault occurs in a left section of the substation; otherwise, the fault occurs in a right section of the substation;
wherein obtaining the values of the required parameters at the time tag and inputting the values into a parameter matrix includes:

obtaining a current $I_3$ from the diode-connection device at the local substation at the time tag, using the GOOSE network to read a current $I_4$ from the diode-connection device at the neighboring substation at the time tag, along with feeder currents $I_2$ and $I_1$ from the neighboring and local substations, respectively, and entering $I_1$, $I_2$, $I_3$ and $I_4$ into the following system of equations:

$$\begin{cases} \left[(\alpha+\beta)(R_1+R_3)+R_4\right]I_1 + R_4 I_2 - \alpha R_1 I_4 + \alpha R_3 I_3 = 0 \\ \left[(\alpha+\beta)(R_2-R_3)+R_4\right]I_2 + R_4 I_1 - \alpha(R_2-R_3)I_3 = 0 \\ \left[(1+\alpha)R_2+R_5\right]I_3 + \alpha R_3 I_1 - \alpha(R_2-R_3)I_2 + R_5 I_4 = u_1 \\ \left[(1+\alpha)R_1+R_5\right]I_4 - \alpha R_1 I_1 + R_5 I_3 = u_2 \\ R_1 + R_2 = r \end{cases}$$

Arranging into the following matrix:

$$\left( \begin{array}{ccccc|c} (\alpha+\beta)I_1-\alpha I_4 & 0 & (\alpha+\beta)I_1+\alpha I_3 & (I_1+I_2) & 0 & 0 \\ 0 & (\alpha+\beta)I_2-\alpha I_3 & -(\alpha+\beta)I_2+\alpha I_3 & (I_1+I_2) & 0 & 0 \\ 0 & (\alpha+1)I_3-\alpha I_2 & \alpha(I_1+I_2) & 0 & (I_3+I_4) & u_1 \\ (\alpha+1)I_4-\alpha I_1 & 0 & 0 & 0 & (I_3+I_4) & u_2 \\ 1 & 1 & 0 & 0 & 0 & r \end{array} \right)$$

where $\alpha$ is a ratio of a contact net unit resistance to a return rail unit resistance, $\beta$ is a ratio of the contact net unit resistance to the rail unit resistance, $u_1$ is an output voltage of a rectifier on the left side, $u_2$ is an output voltage of the rectifier on the right side, and r is a total resistance of a contact net in a section;

$R_1$ is a contact net resistance on the left side of a train, $R_2$ is the contact net resistance on the right side of the train, $R_3$ is a resistance between a return rail short circuit point and a train's current pickup point, $R_4$ is an equivalent resistance at a short circuit point, and $R_5$ is a train's equivalent resistance.

2. The method according to claim 1, wherein, the preset fault determination strategy includes:
getting a current sample value of the diode-connection devices from neighboring substations on both sides of the local substation through the GOOSE network, and determining that the neighboring substation with the higher current sample value is the side experiencing the short-circuit fault.

3. The method according to claim 1, wherein, obtaining the values of the required parameters at the time tag and inputting the values into a parameter matrix includes:
getting the current $I_1$ and $I_3$ of the feeder and the diode-connection devices of the local substation at the time tag and the currents $I_2$ and $I_4$ of the feeder and diode-connection devices of the neighboring substation at the time tag through the GOOSE network, and inputting $I_1$, $I_2$, $I_3$ and $I_4$ into the parameter matrix.

4. An electronic device, comprising a processor and a memory that communicates with the processor and is configured to store processor-executable instructions, wherein the processor is configured to perform the method according to any one of claims 1 to 3.

5. A server, comprising at least one processor and a memory that communicates with the at least one processor, the memory storing instructions that is executable by the at least one processor, which, when executed, enable the processor to perform the method according to any one of claims 1 to 3.

6. A computer-readable storage medium, storing a computer program, wherein the computer program, when executed by a processor, implements the method according to any one of claims 1 to 3.

**Patentansprüche**

1. Verfahren zum Erfassen und Lokalisieren eines Negativpol-Erdungsfehlers in Vier-Schienen-Gleichstrom-Traktionssystemen, umfassend:

Abtasten eines Stroms von einer Speiseleitung und einer Diodenverbindungsvorrichtung, wenn voreingestellte Stromvariationsanalysebedingungen erfüllt sind;

Erfassen einer Zeitmarke, wenn der Strom durch die Diodenverbindungsvorrichtung einen Zielschwellenwert erreicht und dann Ausführen einer vordefinierten Fehlerbestimmungsstrategie;

Erhalten von Werten der zum Zeitmarken-Zeitpunkt erforderlichen Parameter und Eingeben der Werte in eine Parametermatrix;

Lösen der Parametermatrix, um Berechnungsergebnisse zu erhalten, und Ableiten eines Fehlerpunkts basierend auf den Berechnungsergebnissen;

wobei die voreingestellten Stromvariationsanalysebedingungen umfassen:

Erfassen eines Stroms $I_d$, der durch Dioden der Diodenverbindungsvorrichtung in Echtzeit fließt, Bestimmen, ob der Strom $I_d$ einen eingestellten Wert $I_{set}$ überschreitet, und wenn der Strom $I_d$ den eingestellten Wert $I_{set}$ überschreitet, Starten der Stromvariationsanalyse;

wobei die Stromvariationsanalyse umfasst:

Initialisieren eines Stromparameters A und eines Stromparameters B auf 0, Aufzeichnen eines Stromwerts zu einem aktuellen Zeitpunkt und Vergleichen des Stromwerts mit einem Strom zu einem vorherigen Zeitpunkt:

wenn der Stromwert zum aktuellen Zeitpunkt niedriger ist als der Stromwert zum vorherigen Zeitpunkt, wird der Stromwert zum vorherigen Zeitpunkt als ein lokales Maximum betrachtet, Aktualisieren des Stromparameters A auf den lokalen Maximalwert;

wenn der Stromparameter A höher ist als der Stromparameter B, Aktualisieren des Stromparameters B auf den Stromparameter A, und Aufzeichnen von Stromwerten der Speiseleitung einer lokalen Unterstation und der Speiseleitung einer benachbarten Unterstation sowie Stromwerten der Diodenverbindungsvorrichtung über ein generisches objektorientiertes Unterstationsereignis (GOOSE)-Netzwerk;

wenn der Stromwert zum aktuellen Zeitpunkt höher ist als der Stromwert zum vorherigen Zeitpunkt, wird der Strom als steigend betrachtet, und der Stromparameter A nicht aktualisiert wird;

wobei die voreingestellte Fehlerbestimmungsstrategie umfasst:

Erhalten eines Stroms $I_{dl}$ der Diodenverbindungsvorrichtung auf einer linken Seite der lokalen Unterstation zum aktuellen Zeitpunkt und eines Stroms $I_{dr}$ der Diodenverbindungsvorrichtung auf einer rechten Seite der lokalen Unterstation zum aktuellen Zeitpunkt über das GOOSE-Netzwerk, und Bestimmen, dass, wenn $I_{dl} > I_{dr}$, der Fehler in einem linken Abschnitt der Unterstation auftritt; andernfalls tritt der Fehler in einem rechten Abschnitt der Unterstation auf;

wobei das Erhalten von Werten der zum Zeitmarken-Zeitpunkt erforderlichen Parameter und das Eingeben der Werte in eine Parametermatrix:

Erhalten eines Stroms $I_3$ von der Diodenverbindungsvorrichtung an der lokalen Unterstation zum Zeitmarken-Zeitpunkt, Verwenden des GOOSE-Netzwerks, um einen Strom $I_4$ von der Diodenverbindungsvorrichtung an der benachbarten Unterstation zum Zeitstempel zu lesen, zusammen mit Speiseleitungsströmen $I_2$ und $I_1$ von der benachbarten bzw. lokalen Unterstation, und Eingeben von $I_1$, $I_2$, $I_3$ und $I_4$ in das folgende Gleichungssystem:

$$\begin{cases} \left[(\alpha+\beta)(R_1+R_3)+R_4\right]I_1 + R_4 I_2 - \alpha R_1 I_4 + \alpha R_3 I_3 = 0 \\ \left[(\alpha+\beta)(R_2-R_3)+R_4\right]I_2 + R_4 I_1 - \alpha(R_2-R_3)I_3 = 0 \\ \left[(1+\alpha)R_2+R_5\right]I_3 + \alpha R_3 I_1 - \alpha(R_2-R_3)I_2 + R_5 I_4 = u_1 \\ \left[(1+\alpha)R_1+R_5\right]I_4 - \alpha R_1 I_1 + R_5 I_3 = u_2 \\ R_1 + R_2 = r \end{cases}$$

Anordnen in die folgende Matrix:

$$\begin{pmatrix} (\alpha+\beta)I_1 - \alpha I_4 & 0 & (\alpha+\beta)I_1 + \alpha I_3 & (I_1 + I_2) & 0 & \Big| & 0 \\ 0 & (\alpha+\beta)I_2 - \alpha I_3 & -(\alpha+\beta)I_2 + \alpha I_3 & (I_1 + I_2) & 0 & \Big| & 0 \\ 0 & (\alpha+1)I_3 - \alpha I_2 & \alpha(I_1 + I_2) & 0 & (I_3 + I_4) & \Big| & u_1 \\ (\alpha+1)I_4 - \alpha I_1 & 0 & 0 & 0 & (I_3 + I_4) & \Big| & u_2 \\ 1 & 1 & 0 & 0 & 0 & \Big| & r \end{pmatrix}$$

wobei $\alpha$ ein Verhältnis eines Kontaktnetz-Einheits-Widerstands zu einem Rückleitungs-schienen-Einheits-Widerstand ist, $\beta$ ein Verhältnis des Kontaktnetz-Einheits-Widerstands zum Schienen-Widerstand ist, $u_1$ eine Ausgangsspannung eines Gleichrichters auf der linken Seite ist, $u_2$ eine Ausgangsspannung des Gleichrichters auf der rechten Seite ist, und r ein Gesamt-Widerstand eines Kontaktnetzes in einem Abschnitt ist;
$R_1$ ist ein Kontaktnetz-Widerstand auf der linken Seite eines Zuges, $R_2$ ist der Kontaktnetz-Widerstand auf der rechten Seite des Zuges, $R_3$ ist ein Widerstand zwischen einem Rückleitungsschienen-Kurzschlusspunkt und einem Stromaufnahmepunkt des Zuges, $R_4$ ist ein äquivalenter Widerstand an einem Kurzschlusspunkt, und $R_5$ ist ein äquivalenter Widerstand des Zuges.

2. Verfahren nach Anspruch 1, wobei die voreingestellte Fehlerbestimmungsstrategie umfasst:
Empfangen eines aktuellen Stromprobenwerts der Diodenverbindungsvorrichtungen von benachbarten Unterstationen auf beiden Seiten der lokalen Unterstation über das GOOSE-Netzwerk und Bestimmen, dass die benachbarte Unterstation mit dem höheren Stromprobenwert die Seite ist, die den Kurzschlussfehler erfährt.

3. Verfahren nach Anspruch 1, wobei das Erhalten von Werten der zum Zeitmarken-Zeitpunkt erforderlichen Parameter und das Eingeben der Werte in eine Parametermatrix umfasst:
Erhalten des Stroms $I_1$ und $I_3$ der Speiseleitung und der Diodenverbindungsvorrichtungen der lokalen Unterstation zum Zeitmarken-Zeitpunkt und der Ströme $I_2$ und $I_4$ der Speiseleitung und Diodenverbindungsvorrichtungen der benachbarten Unterstation zum Zeitmarken-Zeitpunkt über das GOOSE-Netzwerk, und Eingeben von $I_1$, $I_2$, $I_3$ und $I_4$ in die Parametermatrix.

4. Elektronische Vorrichtung, umfassend einen Prozessor und einen Speicher, der mit dem Prozessor kommuniziert und dazu konfiguriert ist, prozessorausführbare Anweisungen zu speichern, wobei der Prozessor dazu konfiguriert ist, das Verfahren nach einem der Ansprüche 1 bis 3 auszuführen.

5. Server, umfassend mindestens einen Prozessor und einen Speicher, der mit dem mindestens einen Prozessor kommuniziert, wobei der Speicher Anweisungen speichert, die durch den mindestens einen Prozessor ausführbar sind, und wobei die Anweisungen, wenn sie ausgeführt werden, den Prozessor dazu befähigen, das Verfahren nach einem der Ansprüche 1 bis 3 auszuführen.

6. Computerlesbares Speichermedium, das ein Computerprogramm speichert, wobei das Computerprogramm, wenn es durch einen Prozessor ausgeführt wird, das Verfahren nach einem der Ansprüche 1 bis 3 implementiert.

**Revendications**

1. Procédé de détermination et de localisation d'un défaut de pôle négatif à la terre dans un système de retour de courant par rail dédié pour métro, **caractérisé en ce qu'**il comprend :

Obtention des courants d'un alimentateur et d'un dispositif de conduction unidirectionnelle, lorsque des conditions prédéfinies d'analyse de variation de courant sont remplies;
Obtention de l'instant correspondant au moment où le courant du dispositif de conduction unidirectionnelle atteint une valeur cible, et exécution d'une stratégie prédéfinie de détermination de défaut;
Obtention des valeurs de paramètres nécessaires à l'instant correspondant et leur introduction dans une matrice de paramètres;
Résolution de la matrice de paramètres, et inférence du point de défaut basée sur les résultats de calcul;
Dans lequel les conditions prédéfinies d'analyse de variation de courant comprennent:

Détection en temps réel du courant Id d'un diode du dispositif de conduction unidirectionnelle, vérification si le courant Id dépasse une valeur définie Iset, et
initiation de l'analyse de variation de courant lorsque le courant Id dépasse la valeur définie Iset;
Dans lequel l'initiation de l'analyse de variation de courant comprend:
tout d'abord, initialisation à zéro d'une valeur maximale locale et d'une valeur maximale globale, enregistrement du courant à l'instant présent, et comparaison avec le courant à l'instant précédent :

Si le courant à l'instant présent est inférieur au courant à l'instant précédent, la valeur maximale locale est définie comme étant le courant à l'instant précédent;
Si la valeur maximale locale est supérieure à la valeur maximale globale, mise à jour de la valeur maximale globale avec le courant à l'instant précédent et enregistrement, via un réseau d'événements de sous-station orienté objet générique (GOOSE), des courants de l'alimentateur d'une sous-station locale, des alimentateurs de sous-stations voisines, et des dispositifs de conduction unidirectionnelle;
Si le courant à l'instant présent est supérieur au courant à l'instant précédent, il est considéré que le courant est en augmentation et la valeur maximale locale n'est pas mise à jour;
dans lequel la stratégie prédéfinie de détermination de défaut comprend:

Obtention, via le réseau GOOSE, du courant Idl à l'instant présent du dispositif de conduction unidirectionnelle du côté gauche de la sous-station locale et d'un courant Idr à l'instant présent du dispositif de conduction unidirectionnelle du côté droit de la sous-station locale, et détermination que le défaut se situe dans la section gauche de la sous-station locale si Idr > Idl; sinon, le défaut se situe dans la section droite de la sous-station locale;
Dans lequel l'obtention des valeurs de paramètres nécessaires à l'instant correspondant et leur introduction dans la matrice de paramètres comprend:

Introduction, dans le système d'équations suivant, du courant obtenu I1 à l'instant correspondant du dispositif de conduction unidirectionnelle de la sous-station locale, ainsi que du courant I2 à l'instant présent du dispositif de conduction unidirectionnelle de la sous-station voisine, du courant I3 de l'alimentateur de la sous-station voisine, et du courant I4 de l'alimentateur de la sous-station locale, tous obtenus via le réseau GOOSE:

$$\begin{cases} \left[(\alpha+\beta)(R_1+R_3)+R_4\right]I_1 + R_4I_2 - \alpha R_1I_4 + \alpha R_3I_3 = 0 \\ \left[(\alpha+\beta)(R_2-R_3)+R_4\right]I_2 + R_4I_1 - \alpha(R_2-R_3)I_3 = 0 \\ \left[(1+\alpha)R_2+R_5\right]I_3 + \alpha R_3I_1 - \alpha(R_2-R_3)I_2 + R_5I_4 = u_1 \\ \left[(1+\alpha)R_1+R_5\right]I_4 - \alpha R_1I_1 + R_5I_3 = u_2 \\ R_1 + R_2 = r \end{cases}$$

Mise sous la forme de matricielle suivante:

$$\left(\begin{array}{ccccc|c} (\alpha+\beta)I_1-\alpha I_4 & 0 & (\alpha+\beta)I_1+\alpha I_3 & (I_1+I_2) & 0 & 0 \\ 0 & (\alpha+\beta)I_2-\alpha I_3 & -(\alpha+\beta)I_2+\alpha I_3 & (I_1+I_2) & 0 & 0 \\ 0 & (\alpha+1)I_3-\alpha I_2 & \alpha(I_1+I_2) & 0 & (I_3+I_4) & u_1 \\ (\alpha+1)I_4-\alpha I_1 & 0 & 0 & 0 & (I_3+I_4) & u_2 \\ 1 & 1 & 0 & 0 & 0 & r \end{array}\right)$$

où $\alpha$ est le rapport de la résistance unitaire du réseau de contact à la résistance unitaire du rail de retour, $\beta$ est le rapport de la résistance unitaire du réseau de contact à la résistance unitaire du rail, u1 est la tension de sortie d'un redresseur de la sous-station à gauche, u2 est la tension de sortie d'un redresseur de la sous-station à droite, et r est la résistance totale du réseau de contact dans cette section;
R1 est la résistance du réseau de contact du côté gauche d'un train, R2 est la résistance du réseau de contact du côté droit du train, R3 est la résistance entre le point de court-circuit du rail de retour et le point de prise de courant du train, R4 est la résistance équivalente du point de court-circuit, et R5 est la résistance équivalente du train.

2. Procédé selon la revendication 1, **caractérisé en ce que** la stratégie prédéfinie de détermination de défaut comprend:
Obtention, via le réseau GOOSE, des courants des dispositifs de conduction unidirectionnelle dans les sous-stations voisines de la sous-station locale, et identification de la sous-station voisine présentant le courant le plus élevé comme étant le côté du défaut.

3. Procédé selon la revendication 1, **caractérisé en ce que** l'obtention des valeurs de paramètres nécessaires à l'instant correspondant et leur introduction dans la matrice de paramètres comprend:
Obtention, via le réseau GOOSE, des courants suivants à l'instant correspondant: courant I4 de l'alimentateur de la sous-station locale, courants I3 et I2 de l'alimentateur et du dispositif de conduction unidirectionnelle de la sous-station voisine, ainsi que du courant I1 du dispositif de conduction unidirectionnelle de la sous-station locale, et leur introduction dans la matrice de paramètres.

4. Dispositif électronique, comprenant un processeur et une mémoire qui communique avec le processeur et qui est configurée pour enregistrer des instructions exécutables par le processeur, **caractérisé en ce que** le processeur est configuré pour implémenter le procédé de détermination et de localisation d'un défaut de pôle négatif à la terre dans un système de retour de courant par rail dédié pour métro selon l'une quelconque des revendications 1 à 3.

5. Serveur, **caractérisé en ce qu'**il comprend au moins un processeur et une mémoire qui communique avec le processeur, la mémoire enregistre des instructions exécutables par le au moins un processeur, et l'exécution des instructions par le processeur permet au au moins un processeur d'implémenter le procédé de détermination et de localisation d'un défaut de pôle négatif à la terre dans un système de retour de courant par rail dédié pour métro selon l'une quelconque des revendications 1 à 3.

6. Support de stockage lisible par ordinateur, enregistrant un programme informatique, **caractérisé en ce que** le programme informatique, lorsqu'il est exécuté par un processeur, le procédé de détermination et de localisation d'un défaut de pôle négatif à la terre dans un système de retour de courant par rail dédié pour métro selon l'une quelconque des revendications 1 à 3.

**FIG. 1**

**FIG. 2**

**FIG. 3**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 116500378
- CN 111478298